# EUROPÄISCHE PATENTANMELDUNG

(11) **EP 2 023 442 A2**
(43) Veröffentlichungstag der Anmeldung: **11.02.2009**
(21) Anmeldenummer: 08013738.3
(22) Anmeldetag: 31.07.2008
(51) Int. Cl.: H01R 12/12

(54) **Mehrteilige Platine**

(30) Priorität: 10.08.2007 DE 102007038054
(71) Anmelder: VEGA Grieshaber KG, 77709 Wolfach (DE)
(72) Erfinder: Becherer, Frank, 77716 Haslach (DE); Rauer, Winfried, 77716 Fischerbach (DE); Koernle, Ralf, 77736 Zell a. H. (DE)
(74) Vertreter: Göhring, Robert

(57) **Zusammenfassung**

Mehrteilige Platine mit wenigstens zwei Teilplatinen (1, 2, 3, 4) und flexiblen Signalverbindung (7), wobei an wenigstens einer Teilplatine (1) wenigstens ein Klemmelement (10) angeformt ist, das in wenigstens eine Klemmöffnung (12) einer anderen Teilplatine (4) einführbar ist

## Beschreibung

Die Erfindung betrifft eine mehrteilige Platine, gemäß den o-berbegrifflichen Merkmalen eines Patentanspruchs 1.

Mehrteilige Platinen sind aus dem Stand der Technik bekannt, um größere Schaltungsanordnungen, in bspw. zylindrisch ausgeformten Gehäusen unterzubringen. Eine derartige mehrteilige Platine besteht dabei aus mehreren Teilplatinen, die über flexible Signalverbindungen, bspw. Bandkabel, miteinander verbunden sind und wird in einer Einsatzkonfiguration zwischen den Teilplatinen abgewinkelt, so dass bspw. ein vierseitiger Hohlzylinder entsteht, der in das zylindrisch ausgeformte Gehäuse eingeschoben werden kann. Um die einzelnen Teilplatinen in einer definierten Position zueinander zu fixieren, ist es nach dem Stand der Technik üblich, die einzelnen Teilplatinen zu verkleben oder durch weitere Zubehörteile, bspw. Steckverbindern oder Rahmen, relativ zueinander zu fixieren. Von der Firma Skiffy sind beispielsweise sogenannte PCB Spacer bekannt, mit denen mehrteilige Platinen in einem bestimmten Abstand zueinander fixiert werden können.

Nachteilig an solchen Verbindungsmöglichkeiten ist, dass eine Fixierung mittels Steckverbindern oder Rahmen zusätzliche Arbeitsgänge zur Montage dieser Zubehörteile, sowie die entsprechenden Kosten für die Zubehörteile verursacht. Für den Fall, dass die Leiterplatten miteinander verklebt werden, können des Weiteren Probleme durch chemische Reaktionen des Klebstoffes mit anderen Vergussmassen, bzw. den Platinen auftreten. Dies ist zeit- und kostenintensiv und birgt weitere Fehler- und/oder Problemquellen.

Es ist die Aufgabe der Erfindung eine mehrteilige Platine zur Verfügung zu stellen, mit der es möglich ist, zwei oder mehrere Leiterplatten ohne weitere Montageteile in einer definierten Position zueinander fixieren. Des Weiteren soll eine schnellere und günstigere Montage der mehrteiligen Platine möglich sein.

Diese Aufgabe wird gelöst durch eine mehrteilige Platine mit den Merkmalen des Patentanspruchs 1.

Eine erfindungsgemäße mehrteilige Platine weist wenigstens zwei Teilplatinen und dazwischen angeordnete, flexible Verbindungen auf, wobei an einer ersten Teilplatine wenigstens ein Klemmelement angeformt ist, das in wenigstens eine Klemmöffnung einer anderen Teilplatine einführbar ist.

Durch eine erfindungsgemäße Ausgestaltung, der mehrteiligen Platine ist es möglich, zwei Teilplatinen zueinander zu fixieren ohne dass weitere Montageelemente oder eine Klebung notwendig sind. Vorteilhaft an der derartigen Ausgestaltung ist insbesondere eine geringe Montagezeit, sowie eine erhöhte Temperaturbeständigkeit der Klemmverbindung im Vergleich zu z.B. Klebeverbindungen.

In einer bevorzugten Ausgestaltungsform der Erfindung ist die Klemmöffnung als Klemmschlitz ausgebildet und das Klemmelement ist einstückig, vorzugsweise seitlich an die Teilplatine angeformt und besteht aus Platinenmaterial. An dieser bevorzugten Ausgestaltungsvariante ist besonders vorteilhaft, dass eine Herstellung von Platine und Klemmelement in einem Arbeitsgang möglich ist und eine Fixierung auf einfache Art und Weise stattfinden kann.

Gemäß einer weiter bevorzugten Ausgestaltungsform sind mehrere, insbesondere zwei, Klemmnasen und Klemmschlitze vorgesehen. Vorteilhaft an einer derartigen Ausgestaltungsform ist, dass eine parallele Anordnung von mehreren Klemmnasen entlang einer Platinenkante eine verdrehsichere Fixierung der Platinen zueinander gewährleistet wird.

Es ist insbesondere vorteilhaft, wenn vier Teilplatinen vorgesehen sind, die zueinander parallel verlaufende Seitenkanten aufweisen und die flexiblen Verbindungen als Verbindungsleitungen und/ oder Signalleitungen ausgebildet sind. Bei einer mehrteiligen Platine mit vier Teilplatinen findet eine erfindungsgemäße Ausgestaltung bevorzugt Anwendung, da die Teilplatinen in ihrer bevorzugten Positionierung im 90° Winkel zueinander stehen und so eine besonders effektive Fixierung durch eine Anordnung mit Klemmnasen und Klemmschlitzen erreicht werden kann.

Vorteilhafte Ausgestaltungen der Erfindung, sowie Weiterbildungen sind Gegenstand der Unteransprüche.

Die Erfindung wird nachfolgen anhand eines Ausführungsbeispiels unter Bezugnahme auf die beigefügten Figuren erläutert.

Es zeigen:
- Figur 1: eine Draufsicht auf eine erfindungsgemäße mehrteilige Platine in Grundkonfiguration,
- Figur 2: eine Draufsicht auf eine mehrteilige Platine in Montagekonfiguration und
- Figur 3: eine perspektivische Darstellung der faltbaren Platinen aus Figur 1 und 2 in Montagekonfiguration.

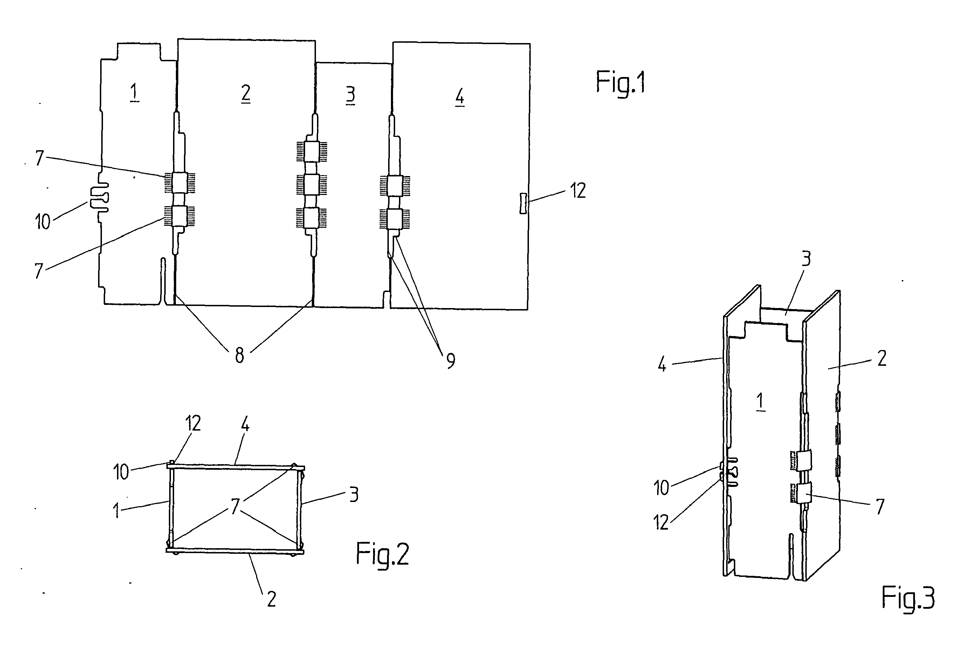

Figur 1 zeigt ein Ausführungsbeispiel einer erfindungsgemäßen mehrteiligen Platine, in ihrer Grundkonfiguration. Die mehrteilige Platine besteht aus vier Teilplatinen 1, 2, 3, 4, die in der Grundkonfiguration starr miteinander verbunden sind. In diesem Zustand wird die mehrteilige Platine mit Bauelementen bestückt und bis zu ihrer vollen Funktionsfähigkeit prozessiert und anschließend getestet. Nach einem erfolgreichen Test wird die mehrteilige Platine an Trennstellen 8 in die Teilplatinen 1, 2, 3, 4 unterteilt und kann dann in Anwendungskonfiguration gebracht werden. An eine erste Teilplatine 1 einer mehrteiligen Platine ist eine Klemmnase 10 angeformt, die in einen Klemmschlitz 12 einer vierten Platine 4 der mehrteiligen Platine einführbar ist. Die einzelnen Teilplatinen 1, 2, 3, 4 weisen vorzugsweise parallel verlaufende Kanten 9 auf, so dass die mehrteilige Platine, wie in den Figuren 2 und 3 dargestellt, in der Anwendungskonfiguration die Form eines vierseitigen Hohlzylinders aufweist. Zwischen den Teilplatinen 1, 2, 3, 4 sind jeweils flexible Verbindungsleitungen 7 angeordnet, die einerseits elektrische Signale zwischen den Teilplatinen 1, 2, 3, 4 leiten können und andererseits als flexible Verbindung der Teilplatinen 1, 2, 3, 4 dienen. Die Klemmnase 10 ist als seitlich geschlitztes Federelement mit einem ersten Schenkel 10a und einem zweiten Schenkel 10b ausgeformt. Eine klemmende Wirkung entsteht dadurch, dass die Klemmnase 10 etwas größer dimensioniert ist als der Klemmschlitz 12. Wird die Klemmnase 10 in den Klemmschlitz 12 eingeführt, so bewegen sich der erste Schenkel 10a und der zweite Schenkel 10b der Klemmnase 10 aufeinander zu und verklemmen im Klemmschlitz 12. Um ein leichteres Einführen der Klemmnase 10 in den Klemmschlitz 12 zu gewährleisten sind die Schenkel 10a, 10b an ihrer Vorderkante angefast.

Figur 2 zeigt eine Draufsicht auf die mehrteilige Platine aus Figur 1 in Anwendungskonfiguration. Wie in Figur 2 dargestellt weist die mehrteilige Platine in ihrer Anwendungskonfiguration einen Querschnitt in Form eines Quadrats auf. An den Seitenflächen des Quadrats sind jeweils die einzelnen Teilplatinen 1, 2, 3, 4 angeordnet. Die Klemmnase 10 der ersten Teilplatine 1 ist in dem Klemmschlitz 12 der vierten Teilplatine 4 eingeführt, so dass durch diese Klemmverbindung die Ausrichtung der ersten Teilplatine 1 zur vierten Teilplatine 4 mit einem 90° Winkel festgelegt ist und die Ausrichtung der zweiten Teilplatine 2 und der dritten Teilplatine 3 bestimmt. Wie in Figur 2 dargestellt sind die erste Teilplatine 1 und die vierte Teilplatine 4 über die Klemmverbindung verbunden, wobei die weiteren Teilplatinen 1, 2, 3, 4, durch die flexiblen Signalverbindungen 7 miteinanderverbunden sind.

Figur 3 zeigt eine perspektivische Darstellung der mehrteiligen Platine in Anwendungskonfiguration. Deutlich zu erkennen ist in dieser Darstellung die quadratische Grundform der mehrteiligen Platine, sowie die Klemmverbindung zwischen der ersten Teilplatine 1 und der vierten Teilplatine 4 durch die Klemmnase 10, die durch den Klemmschlitz 12 geführt ist.

### Bezugszeichenliste

- 1: erste Teilplatine
- 2: zweite Teilplatine
- 3: dritte Teilplatine
- 4: vierte Teilplatine
- 7: Verbindungsleitungen
- 8: Trennstellen
- 9: Kanten
- 10: Klemmelement/ Klemmnase
- 10a: erster Schenkel
- 10b: zweiter Schenkel
- 12: Klemmöffnung/ Klemmschlitz

## Patentansprüche

1. Mehrteilige Platine mit wenigstens zwei Teilplatinen (1, 2, 3, 4) und flexiblen Verbindungsleitungen (7),
**dadurch gekennzeichnet, dass**
an wenigstens einer Teilplatine (1) wenigstens ein Klemmelement (10) angeformt ist, das in wenigstens eine Klemmöffnung (12) einer anderen Teilplatine (4) einführbar ist.

2. Mehrteilige Platine nach Anspruch 1,
**dadurch gekennzeichnet, dass**
die Klemmöffnung als Klemmschlitz (12) ausgebildet ist.

3. Mehrteilige Platine nach einem der vorhergehenden Ansprüche,
**dadurch gekennzeichnet, dass**
das Klemmelement (10) einstückig an die Teilplatine (1) angeformt ist.

4. Mehrteilige Platine nach einem der vorhergehenden Ansprüche,
**dadurch gekennzeichnet, dass**
das Klemmelement als Klemmnase (10) seitlich an die Teilplatine angeformt ist.

5. Mehrteilige Platine nach einem der vorhergehenden Ansprüche,
**dadurch gekennzeichnet, dass**
die Klemmnase (10) aus dem Platinenmaterial ausgeformt ist.

6. Mehrteilige Platine nach einem der vorhergehenden Ansprüche,
**dadurch gekennzeichnet, dass** zwei Klemmnasen (10) und zwei Klemmschlitze (12) vorgesehen sind.

7. Mehrteilige Platine nach einem der vorhergehenden Ansprüche,
**dadurch gekennzeichnet, dass**
die Teilplatinen (1, 2, 3, 4) parallel verlaufende Kanten (9) aufweisen.

8. Mehrteilige Platine nach einem der vorausgehenden Ansprüche,
**dadurch gekennzeichnet, dass**
vier Teilplatinen (1, 2, 3, 4) vorgesehen sind.

9. Mehrteilige Platine nach einem der vorhergehenden Ansprüche
**dadurch gekennzeichnet, dass**
die flexiblen Verbindungen (7) als Verbindungsleitungen und/ oder Signalleitungen ausgebildet sind.
